# EUROPEAN PATENT APPLICATION

(11) **EP 4 719 025 A1**
(43) Date of publication of application: **01.04.2026**
(21) Application number: 25205040.6
(22) Date of filing: 26.09.2025
(51) Int. Cl.: H10P 72/00

(54) **A DEVICE AND A METHOD FOR STRETCHING A WAFER FOIL**

(30) Priority: 27.09.2024 NL 2038729
(71) Applicant: Nexperia B.V., 6534 AB Nijmegen (NL)
(72) Inventor: Huybers, Ralph, Nijmegen (NL); Linders, Bram, Nijmegen (NL)
(74) Representative: Pjanovic, Ilija

(57) **Abstract**

A device is proposed for stretching a wafer foil that is held by a film frame carrier and on which a plurality of electronic components is arranged. In particular, the device comprises a holding member for holding the film frame carrier; a tensioning member structured to engage with the wafer foil. Additionally, it comprises a drive that is structured to move at least the tensioning member from a first operational position, at which an intermediate distance between adjacent electronic components is minimal, towards a second operational position, at which the intermediate distance between adjacent electronic components is maximal, wherein a foil engaging part of the tensioning member engaging with the wafer foil is configured to move from the first operational position towards the second operational position in a direction perpendicular as well as in a direction parallel to a plane defined the wafer foil.

## Description

### TECHNICAL FIELD

The present disclosure relates to a device for stretching a wafer foil that is held by a film frame carrier and on which a plurality of electronic components is arranged as well as a method for stretching such wafer foil. In addition, the present disclosure also pertains to a method for transferring an electronic component, and to a pick-and-place apparatus for transferring an electronic component

### BACKGROUND OF THE DISCLOSURE

In semiconductor assembly, electronic components such as semiconductor dies often need to be transported between a source substrate and a target substrate. For example, the source substrate may comprise a diced or structured semiconductor wafer and the target substrate may comprise a printed circuit board on which one or more of the dies of the diced semiconductor wafer need to be arranged. To enable such transfer, a system for transporting an electronic component is used. Such systems may also be referred to as a pick-and-place apparatus or die placement apparatus, such as a die bonder or die sorter.

Such pick-and-place apparatuses are configured to receive a film frame carrier, that holds a diced or structured semiconductor wafer. For the apparatus to be able to pick up a die, it is needed that the die is separated enough from its neighbouring dies. As the diced or structured semiconductor wafer is provided on a foil, this foil can be stretched to increase the gap between the dies. If the gap between the dies is too small, there is a risk that when a die is picked up, that die or any of the neighbouring dies become damaged.

Accordingly, it is a goal of the present disclosure to provide a wafer foil stretching technique which enables a further increase of the gap between the neighbouring dies, thus further lowering the risk of dies getting damaged during the pick-and-place process, thereby increasing yield.

### SUMMARY OF THE DISCLOSURE

According to a first example of the disclosure, a device is proposed for stretching a wafer foil that is held by a film frame carrier and on which a plurality of electronic components is arranged. In particular, the device comprises a holding member for holding the film frame carrier; a tensioning member structured to engage with the wafer foil. Additionally, it comprises a drive that is structured to move at least the tensioning member from a first operational position, at which an intermediate distance between adjacent electronic components is minimal, towards a second operational position, at which the intermediate distance between adjacent electronic components is maximal.

In particular, that intermediate distance between the adjacent electronic components is further increased as a foil engaging part of the tensioning member engaging with the wafer foil is configured to move from the first operational position towards the second operational position in a direction perpendicular as well as in a direction parallel to a plane defined the wafer foil.

By displacing the tensioning member both in a direction perpendicular as well as in a direction parallel to a plane defined the wafer foil results in an additional stretching of the wafer foil compared to the techniques known in the prior art. This additional stretching results in an additional increase in the intermediate distance between the adjacent electronic components, which additional increase is sufficient to further limit possible damage when the component is picked up.

In a further example, the drive is structured to move the holding member from the first operational position towards the second operational position in a direction perpendicular to the plane defined the wafer foil.

In particular, the tensioning member is composed of a plurality of hinge elements, each hinge element engaging the wafer foil at a discrete contact position, closer to the wafer compared to the techniques known in the prior art. In this way the force from the drive is transferred more efficient to the wafer, resulting in more wafer stretch. And comprising a hinge axis allowing the hinge element to hinge between the first operational position and the second operational position, in which the foil engaging positions are rotated around the film frame carrier. **In** this way the foil is moved further compared to techniques with standard film frame carriers in the prior art. As the plurality of hinge element each engage the wafer foil at discrete contact positions - contrary to the prior art where the tensioning member is formed as a single member contacting the wafer foil - each hinge element is allowed to be moved from the first operational position towards the second operational position in a direction perpendicular as well as in a direction parallel to a plane defined the wafer foil, thus stretching the wafer foil at their discrete contact position over a further distance, which result in an increase in the intermediate distance between the electronic components.

In a preferred example, each hinge element comprises a drive engaging part and the foil engaging part, each being connected with the hinge axis.

In particular, the film frame carrier comprises a ring-like frame in which the wafer foil is held or configured to be held, and which ring-like frame is structured to move the plurality of hinge elements between the first operational position and the second operational position. This allows for a simultaneous activation and moving of the plurality of hinge elements from their first operational position and the second operational position, and thus for a well controlled and even distributed stretching of the wafer foil in all directions.

As the device may comprise a support frame structured to accommodate the plurality of hinge elements in a hinged manner, a compact construction is achieved which facilitates the simultaneous activation and moving of the plurality of hinge elements.

In particular, the plurality of hinge elements are accommodated on the support frame in a ring-like configuration, wherein the number of hinge elements may amount at least 2, in particular 3 or 4, and more in particular 12, 24 or 36. A larger number of hinge elements, preferably oriented in a ring-like configuration, will engage the wafer foil at a larger number of discrete contact positions, which discrete contact positions are likewise oriented in a ring-like configuration. Accordingly, during movement of the plurality of hinge elements between their first operational position towards their second operational position, the wafer foil will be stretched in an evenly distributed manner.

The disclosure also pertains to a method for stretching a wafer foil that is held by a film frame carrier of a device according to disclosure, and on which wafer foil a plurality of electronic components is arranged. In particular, the method comprising the steps of stretching the wafer foil over a tensioning member to thereby increase an intermediate distance between adjacent electronic components by moving the tensioning member in a direction perpendicular as well as in a direction parallel to a plane defined the wafer foil.

In addition, a method for transferring an electronic component is proposed, with the transferring method comprising the steps of providing a film frame carrier that holds a wafer foil on which a plurality of electronic components is arranged; stretching the wafer foil in accordance with any of the previous claims to thereby increase a distance between the adjacent electronic components; picking up an electronic component from the wafer foil; and arranging the electronic components that has been picked up on a target substrate.

Finally, the disclosure also includes a pick-and-place apparatus for transferring an electronic component, comprising the stretching device according to the disclosure; and a pick-up tool configured to pick up an electronic component from the wafer foil and for arranging the electronic component that has been picked up on a target substrate.

### BRIEF DESCRIPTION OF THE DRAWINGS

The disclosure will now be discussed with reference to the drawings, which show in:
Figures 1a and 1b various stages of a device for stretching a wafer foil according to the state of the art;
Figures 2a, 2b and 2c various stages of a device for stretching a wafer foil according to the disclosure;
Figures 3a and 3b details of a device for stretching a wafer foil according to the disclosure in a first operational condition;
Figure 4 a further detail of a device for stretching a wafer foil according to the disclosure in a first operational condition;
Figures 5a and 5b details of a device for stretching a wafer foil according to the disclosure in a first operational condition;
Figures 6a and 6b details of a device for stretching a wafer foil according to the disclosure in a second operational condition;
Figure 7 a further detail of a device for stretching a wafer foil according to the disclosure in a first operational condition;

### DETAILED DESCRIPTION OF THE DISCLOSURE

For a proper understanding of the disclosure, in the detailed description below corresponding elements or parts of the disclosure will be denoted with identical reference numerals in the drawings.

As outlined in the introduction, for a die pick up tool being able to pick up a die from a diced or structured semiconductor wafer placed on a stretchable foil, a gap is to be created in order to separate the dies enough from its neighboring dies. Such a gap is created through wafer foil stretching. As the diced or structured semiconductor wafer is provided on a foil, this foil can be stretched to create or increase the existing gap between the dies.

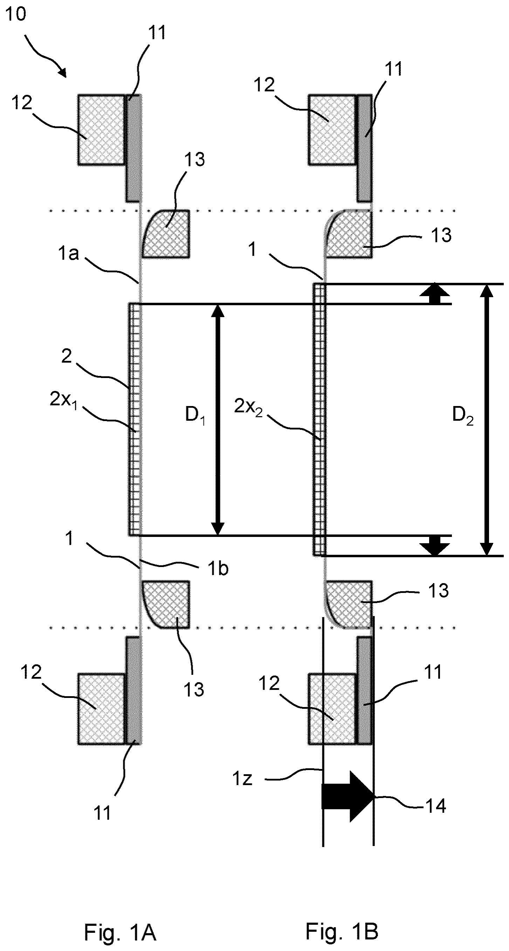

The stretching principle of a wafer foil thus creating an intermediate gap or space between neighboring dies is a known technique, as clarified with respect to Figures 1a and 1b, showing various stages of a device for stretching a wafer foil according to the state of the art.

Reference number 10 depicts a known device for stretching a wafer foil 1, which may be a pick-and-place apparatus. The device 10 is configured to transfer a semiconductor die 2 arranged on wafer foil 1, which is typically transparent. To this end, pick-and-place apparatus comprises a pickup tool that is configured to pick up the semiconductor die 2 from wafer foil 1 and to arrange the semiconductor die 2 that has been picked up on a target substrate. The pick-up tool 10 is known in the art and may comprise a vacuum nozzle.

The wafer foil 1 holds a variety of semiconductor dies 2, which are positioned with respect to each other at an initial, minimal intermediate space or gap 2x₁ (see Figure 1a). This initial, minimal intermediate space or gap 2x₁ is insufficient large to allow a proper (sic. fast, efficient, with less damage) pick up of an individual die 2. The wafer foil 1 is held by a film frame carrier 11. In particular, the device 10 comprises a holding member 12 for holding the film frame carrier 11 and is connected to the drive and able to move and apply the needed force, as well as a tensioning member 13. The tensioning member 13 engages the wafer foil.

A drive - not shown in Figures 1a and 1b, but denoted by means of the bold arrow at the bottom of Figure1b - is capable of displacing or moving at least the tension member 13 with respect to the wafer foil 1. In particular the displacement of at least the tension member 13 is initially from a first operational position, which position is shown in Figure 1a towards a second operational position, which position is shown in Figure 1b. In that first operational position, the tensioning member 13 does not yet or barely contact the wafer foil 1, and accordingly the intermediate distance 2x₁ between adjacent electronic components (dies) 2 is minimal, as the wafer foil is not yet subjected to any stretching. The length dimension of the diced or structured semiconductor wafer on the unstretched wafer foil 1 in Figure 1a is D₁.

In the second operational position, the holding member 12 is displaced in a direction perpendicular to and past the plane defined the wafer foil 1. Accordingly the intermediate distance 2x₁ between adjacent electronic components (dies) 2 is increased to an intermediate distance 2x₁ between adjacent electronic components, which is considered maximal. Likewise, the increased length dimension of the diced or structured semiconductor wafer on the stretched wafer foil 1 in Figure 1b is D₂.

The remaining figures disclose a device according to the present disclosure implementing a wafer foil stretching technique which enables a further increase of the gap 2x between the neighboring dies 2. The further gap increase ensures that the risk of dies getting damaged during the pick-and-place process is significantly lowered, thereby increasing yield and quality of the device according to the disclosure.

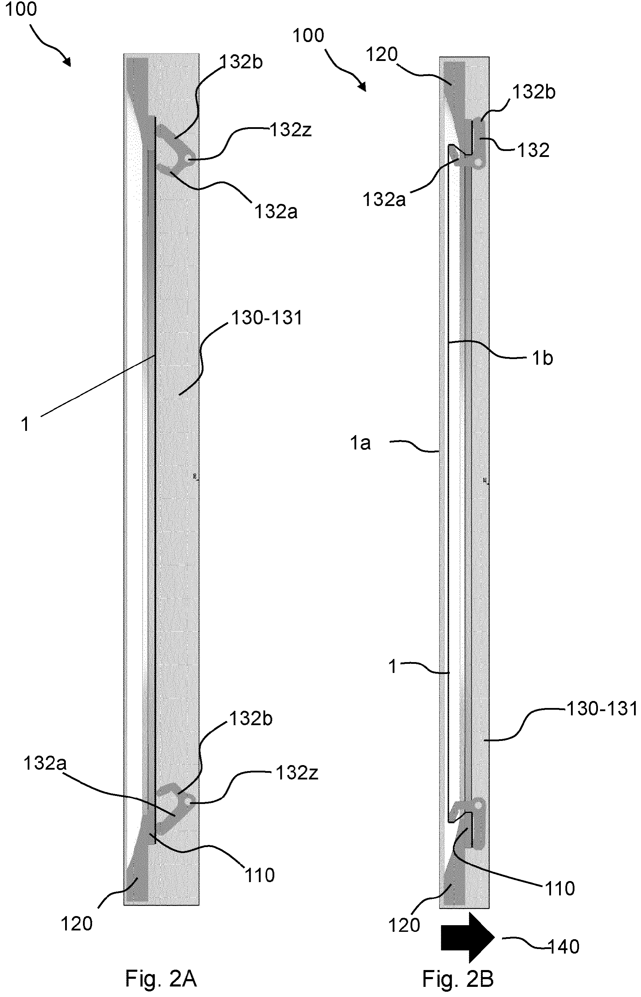

Figures 2a and 2b depict the two stages of a device for stretching a wafer foil according to the disclosure, analogue to the stages of Figures 1a and 1b.

Reference numeral 100 denotes a device according to the disclosure for stretching a wafer foil 1. In a similar fashion, the wafer foil 1 is held by a film frame carrier 110 and a holding member 120 holds the film frame carrier 110. Likewise, a tensioning member 130 engages with the wafer foil 1. The wafer foil 1 has a first foil surface 1a and a second foil surface 1b, opposite to the first foil surface 1a. The diced or structured semiconductor wafer consisting of a plurality of spaced apart semiconductors components (dies) 2 is placed on the first foil surface 1a.

In the first operational position of Figure 2a, which operational position is similar to that of Figure 1a, the tensioning member 130 does not yet or barely contact the wafer foil 1, and accordingly the intermediate distance 2x₁ between adjacent electronic components (dies) 2 is minimal, as the wafer foil is not yet subjected to any stretching.

A drive - not shown in Figures 2a and 2b, but denoted by means of the bold arrow at the bottom of Figure 2b is capable of displacing or moving at least the tensioning member 130 with the assistance of the holding member 120 with respect to the wafer foil 1. In particular the displacement of at least the tensioning member 130 is performed in an indirect manner, as the holding member 120 is actively driven by the drive. Under the influence of the holding member 120 being displaced, the tensioning member 130 is initially from a first operational position, which position is shown in Figure 2a towards a second operational position, which position is shown in Figure 2b.

In the second operational position, see Figure 2b, a foil engaging part 132a of the tensioning member 130 is displaced in a direction perpendicular to and past the plane defined the wafer foil 1, as well as in a direction parallel to the plane defined the wafer foil 1. The translational movement of the holding member 120 from the first operational position (Figure 2a) towards the second operational position (Figure 2b) is converted into a resulting movement in the tensioning member 130 direction perpendicular to and past the plane, as well as in a direction parallel to the plane. This resulting movement can be considered as a rotating movement around a pivot point or axis.

This resulting rotating movement both in a direction perpendicular as well as in a direction parallel to a plane defined the wafer foil 1 results in an additional stretching of the wafer foil compared to the techniques known in the prior art. This additional stretching results in an additional increase in the intermediate distance between the adjacent electronic components (dies) 2, which additional increase is sufficient to further limit possible damage when the die or component 2 is picked up.

In particular, the drive is structured to move the holding member 120 from the first operational position towards the second operational position in a direction perpendicular to the plane defined the wafer foil 1. This direction perpendicular to the plane is defined by the bold arrow in Figure 2b.

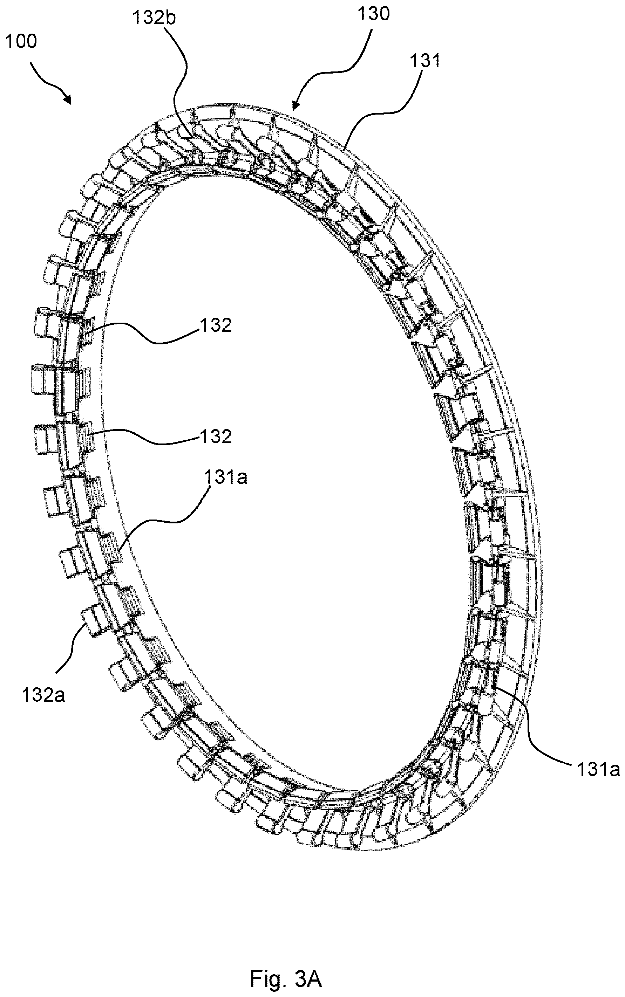

As shown in Figure 3a, the tensioning member 130 is composed of a circular of ring shaped support frame 131 that holds a plurality of hinge elements 132. The ring shaped support frame 131 comprises a plurality of slots or openings 131a, which are arranged in a circular manner next to each other. The ring shaped support frame 131 forms a compact construction which facilitates the simultaneous activation and hinging of the plurality of the hinge elements 132. Each hinge element 132 engages the second foil surface 1b of the wafer foil 1 at a discrete contact position.

The number of hinge elements 132 may amount at least 2, in particular 3 or 4, and more in particular 12, 24 or 36. A larger number of hinge elements 132, preferably oriented in the ring-like configuration of Figure 3a, engage the wafer foil 1 at a larger number of discrete contact positions, which discrete contact positions are likewise oriented in a ring-like configuration. Accordingly, during movement of the plurality of hinge elements 132 between their first operational position towards their second operational position, the wafer foil 1 will be stretched in an evenly distributed manner.

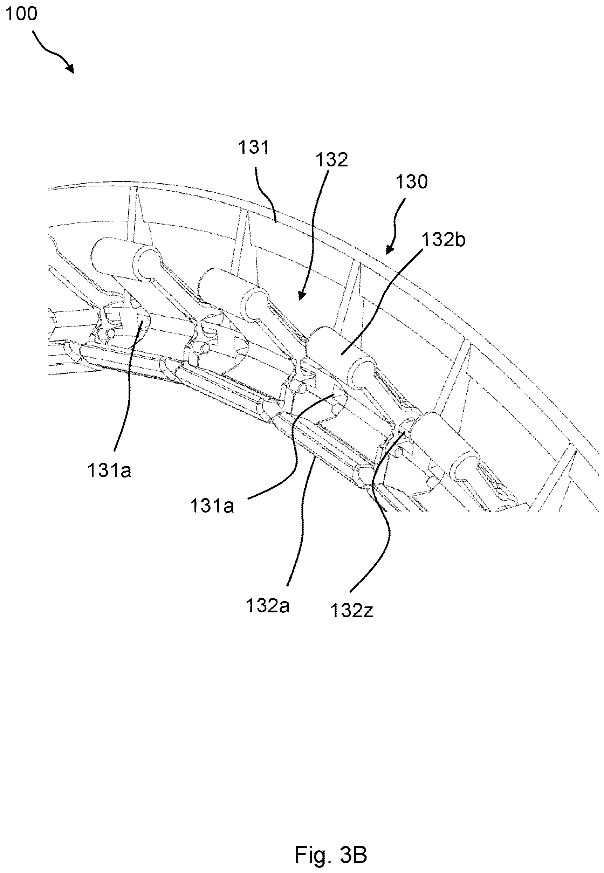

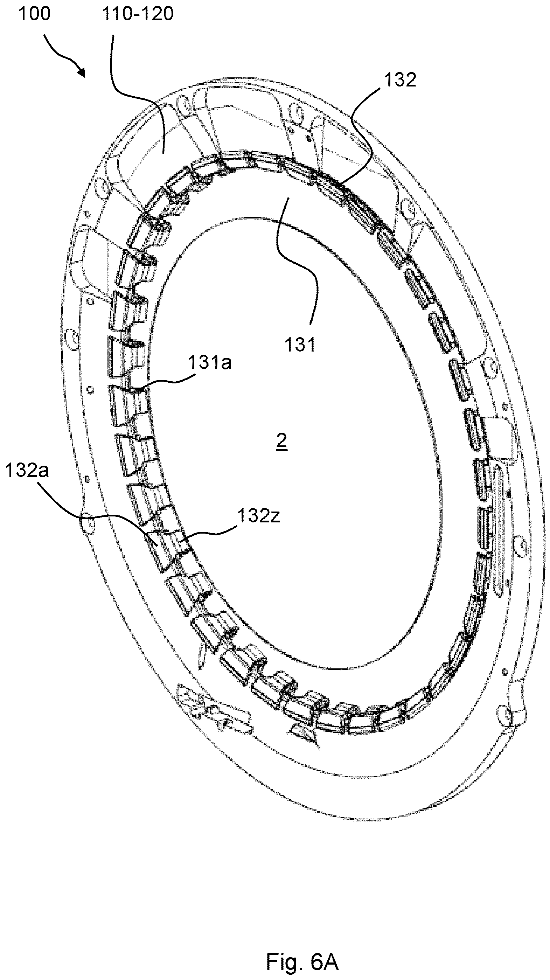

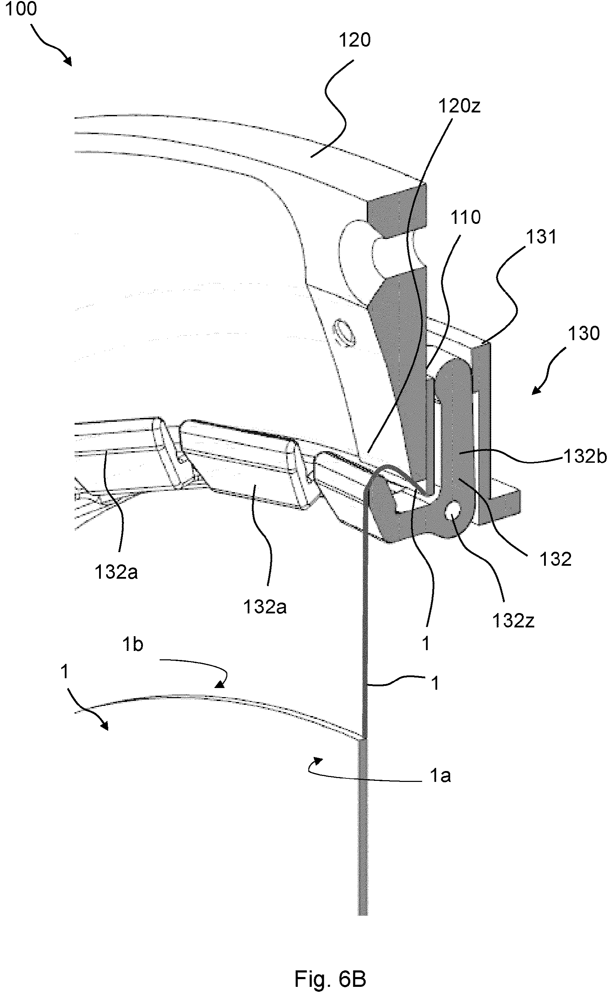

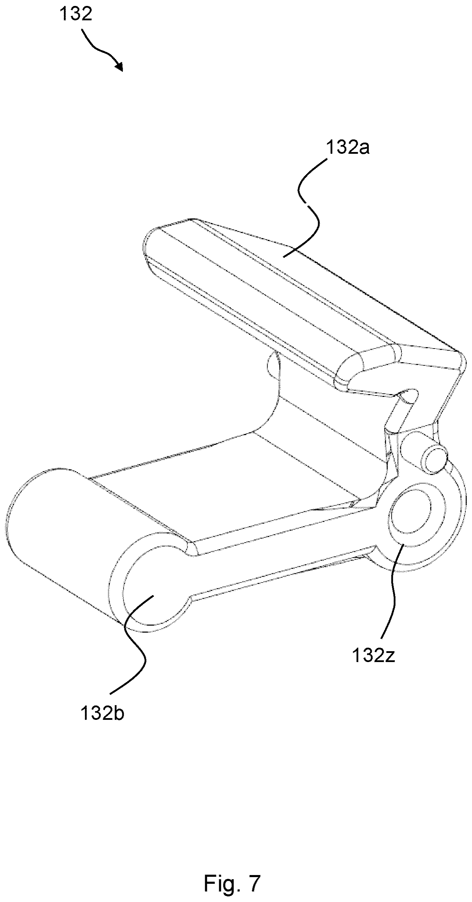

A detailed view of a hinge element 132 is shown in Figure 7. It comprises a hinge axis 132z, which is accommodated in a corresponding slot or opening 131a provided in the ring shaped support frame 131. The hinge axis 132z ascertains that the hinge element 132 as accommodated in the corresponding slot or opening 131a can hinge between the first operational position (Figures 2a, 3a, 3b) and the second operational position (Figures 2b, 6a, 6b). In addition, each hinge element 132 consists of the foil engaging part 132a, which engages or contacts the wafer foil 1 at a discrete position during the transition from the first operational condition towards the second operational condition. Each hinge element 132 furthermore consists of a drive engaging part 132b. The drive engaging part 132b serves as actuating part of the hinge element 132 as it is actuated by the holding member 120. The foil engaging part 132a and the drive engaging part 132b are connected with each other via the hinge axis 132z.

As the plurality of hinge elements 132 each engage the wafer foil 1 at discrete contact positions forming a circular orientation - contrary to the prior art where the tensioning member is formed as a single member contacting the wafer foil - each hinge element 132 is allowed to undergo a rotational movement around their corresponding hinge axis 132z from the first operational position towards the second operational position in a direction perpendicular as well as in a direction parallel to a plane defined the wafer foil 1. The wafer foil 1 is stretched by each individual hinge element 132 at each discrete contact position over a further distance, which result in an increase in the intermediate distance 2x between the electronic components (dies) 2.

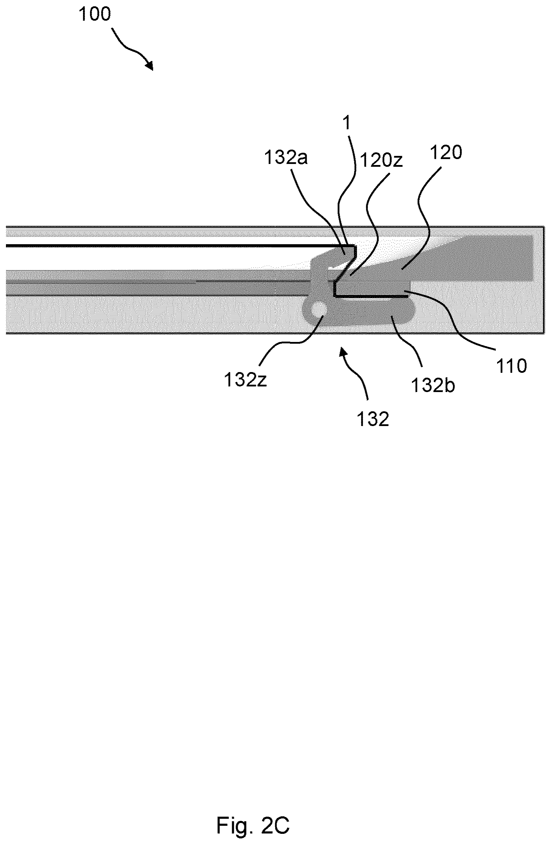

More in particular, each hinge element 132 'grips' the wafer foil 1 at a closer position to the diced or structured semiconductor wafer 2 and 'folds' this gripping point of the wafer foil 1 around the inner edge of the holding member 120. See the detail of Figure 2C as well as Figure 6B. At the moment that the hinge elements 132 each grip at the wafer foil 1, the hinge elements 132 are positioned within the 'working area' of the pickup unit (needle) (not shown). And the hinge elements 132 subsequently rotate away from this working area in a direction parallel to the plane of the wafer foil 1, the working area is cleared, after which the pickup process can take place.

Moreover, once rotated, the hinge elements 132 fold the wafer foil 1 around the inner edge 120z of the holding member 120, see Figure 2C, preventing any translational movement of the holding member 120 and preventing any loading and unloading no longer possible. Accordingly, because of the rotational movement of the hinge elements 132 from the first towards the second operational condition, it is possible that the hinge elements 132 reach areas where this is normally (in the prior art) not possible.

The displacement of the various hinge elements 132 from the initial first operational condition towards the second operational condition is established via the holding member 120 (and the film frame carrier 110), which are actuated by the drive (not shown). The film frame carrier 110 comprises a ring-like frame in which the wafer foil 1 is held in a clamping manner. The plurality of hinge elements 132 are oriented in a circular manner on the ring shaped support frame 131. Upon actuating the drive, the holding member 120 and in particular the ring-like film frame carrier 110 contacts all drive engaging parts 132b of the hinge elements 132 at the same moment.

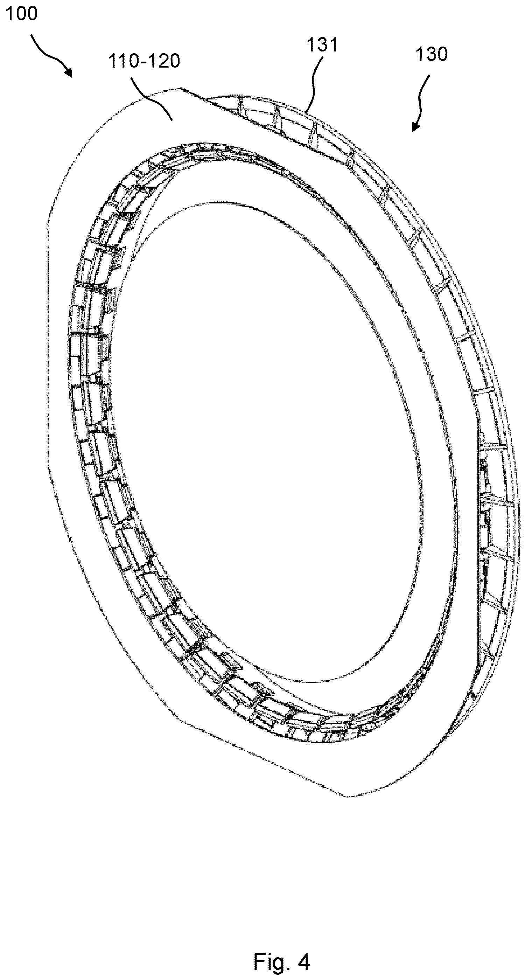

This first operational condition is depicted in Figures 3a-3b and 4.

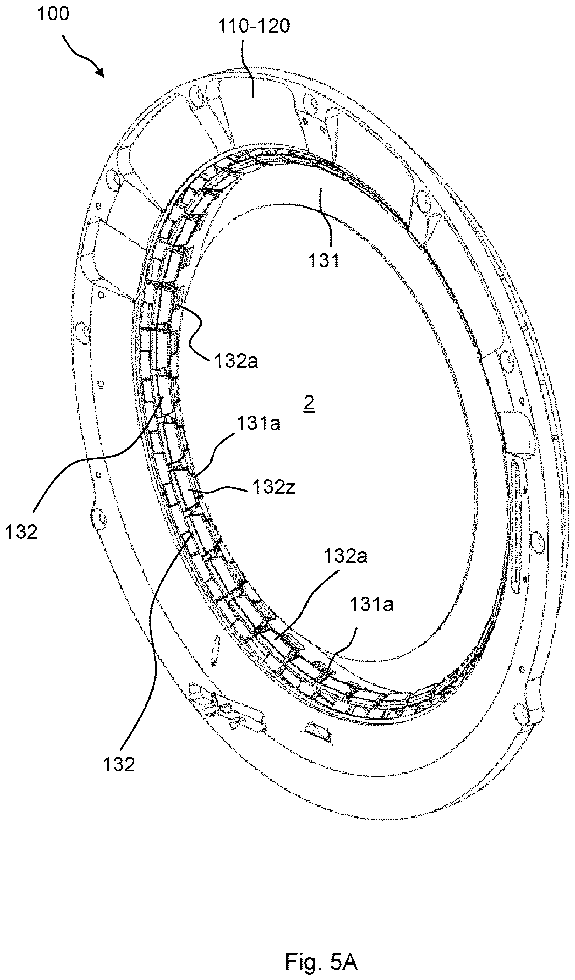

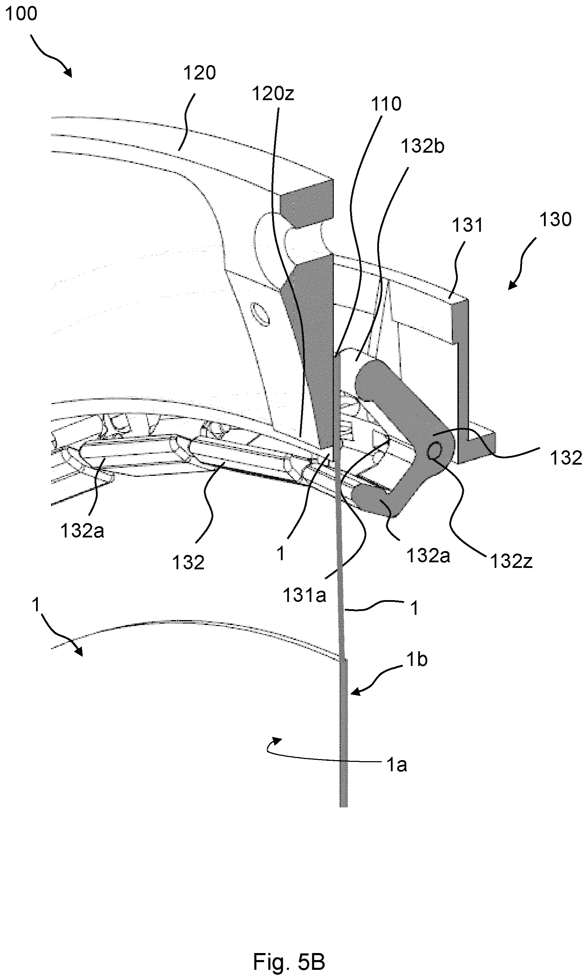

Upon further displacement of the ring-like film frame carrier 110 through the drive, the hinge elements 132 continue to hinge about their hinge axis 132z and the corresponding foil engaging parts 132a displace in a direction perpendicular to the plane defined the wafer foil 1. Figures 5a and 5b depict this intermediate operational condition.

Further actuation and displacement of the ring-like film frame carrier 110 through the drive cause the hinge elements 132 continue to hinge about their hinge axis 132z and the corresponding foil engaging parts 132a displace in a direction perpendicular to the plane defined the wafer foil 1 as well as in a direction parallel to the plane defined the wafer foil 1. Figures 6a-6b depict this second operational condition, wherein the wafer foil 1 is stretched by each individual hinge element 132 at each discrete contact position over a further distance, which result in an increase in the intermediate distance 2x between the electronic components (dies) 2. A well controlled and even distributed stretching of the wafer foil 1 in all directions is herewith established, ensuring a correct increase of the intermediate distance or gap 2x between neighboring dies 2.

The above disclosure of a wafer foil stretching device 100 can be implemented in a pick-and-place apparatus for transferring an electronic component 2. The pick-and-place apparatus is considered also being part of the disclosure and implements, next to the wafer foil stretching device 100 for stretching the wafer foil 1 also a pick-up tool configured to pick up an electronic component 2 from the wafer foil 1 being stretched and arranged to move or position the electronic component 2 thus picked up on a target substrate (not shown).

The disclosure also pertains to a method for stretching a wafer foil 1 that is held by a film frame carrier of a device 100 according to disclosure, and on which wafer foil a plurality of electronic components 2 is arranged. In particular, the method comprising the steps of stretching the wafer foil 1 over a tensioning member 130 to thereby increase an intermediate distance 2x between adjacent electronic components 2 by moving the tensioning member 130 in a direction perpendicular as well as in a direction parallel to a plane defined the wafer foil 1.

In addition, a method for transferring an electronic component is proposed, with the transferring method comprising the steps of providing a film frame carrier that holds a wafer foil on which a plurality of electronic components is arranged; stretching the wafer foil in accordance with any of the previous claims to thereby increase a distance between the adjacent electronic components; picking up an electronic component from the wafer foil; and arranging the electronic components that has been picked up on a target substrate.

### LIST OF REFERENCE NUMERALS USED

- 1: wafer foil
- 1a: first foil side
- 1b: second foil side
- 2: electronic component
- 2x_{1,2}: intermediate distance between adjacent electronic components
- 10: device for stretching a wafer foil (according to the prior art)
- 11: film frame carrier
- 12: holding member
- 13: tensioning member
- 14: drive
- 100: device for stretching a wafer foil (according to the disclosure)
- 110: (ring-like) film frame carrier
- 120: holding member
- 120z: inner edge of holding member
- 130: tensioning member
- 131: tension support frame (tension support frame ring)
- 131a: frame slot for hinge element
- 132: hinge element
- 132z: hinge axis of hinge element
- 132a: foil engaging part of hinge element
- 132b: drive engaging part of hinge element
- 140: drive

## Claims

1. A device for stretching a wafer foil that is held by a film frame carrier and on which a plurality of electronic components is arranged, the device comprising:
- a holding member for holding the film frame carrier;
- a tensioning member structured to engage with the wafer foil;
- a drive structured to move at least the tensioning member from a first operational position, at which an intermediate distance between adjacent electronic components is minimal, towards a second operational position, at which the intermediate distance between adjacent electronic components is maximal,
wherein a foil engaging part of the tensioning member engaging with the wafer foil is configured to move from the first operational position towards the second operational position in a direction perpendicular as well as in a direction parallel to a plane defined the wafer foil.

2. The device according to claim 1, wherein the drive is structured to move the holding member from the first operational position towards the second operational position in a direction perpendicular to the plane defined the wafer foil.

3. The device according to claim 1 or 2, wherein the tensioning member is composed of a plurality of hinge elements, each hinge element comprising a hinge axis allowing the hinge element to hinge between the first operational position and the second operational position.

4. The device according to claim 3, wherein each hinge element comprises a drive engaging part and the foil engaging part, each being connected with the hinge axis.

5. The device according to claim 3 or 4, wherein the film frame carrier comprises a ring-like frame in which the wafer foil is held or configured to be held, and which ring-like frame is structured to move the plurality of hinge elements between the first operational position and the second operational position.

6. The device according to any one or more of the claims 3-5, wherein the device comprises a support frame structured to accommodate the plurality of hinge elements in a hinged manner.

7. The device according to claim 6, wherein the plurality of hinge elements are accommodated on the support frame in a ring-like configuration.

8. The device according to any one or more of the claims 3-7, wherein the number of hinge elements amounts at least 2, in particular 3 or 4, and more in particular 12, 24 or 36.

9. A method for stretching a wafer foil that is held by a film frame carrier of a device according to any one or more of the preceding claims, and on which wafer foil a plurality of electronic components is arranged, the method comprising the steps of:
stretching the wafer foil over a tensioning member to thereby increase an intermediate distance between adjacent electronic components by moving the tensioning member in a direction perpendicular as well as in a direction parallel to a plane defined the wafer foil.

10. A method for transferring an electronic component, comprising:
providing a film frame carrier that holds a wafer foil on which a plurality of electronic components is arranged;
stretching the wafer foil using device according to any one or more of the claims 1-8 to thereby increase
a distance between the adjacent electronic components;
picking up an electronic component from the wafer foil; and
arranging the electronic components that has been picked up on a target substrate.

11. A pick-and-place apparatus for transferring an electronic component, comprising:
the stretching device according to any of the claims 1-8; and
a pick-up tool configured to pick up an electronic component from the wafer foil and for arranging the electronic component that has been picked up on a target substrate.
